(19) Europäisches Patentamt
European Patent Office
Office européen des brevets

(11) **EP 3 844 402 B1**

(12) **EUROPEAN PATENT SPECIFICATION**

(45) Date of publication and mention
of the grant of the patent:
**09.08.2023 Bulletin 2023/32**

(21) Application number: **19769904.4**

(22) Date of filing: **21.08.2019**

(51) International Patent Classification (IPC):
*F15B 19/00* (2006.01)    *F16K 37/00* (2006.01)
*F15B 13/044* (2006.01)    *F15B 20/00* (2006.01)
*G01R 31/28* (2006.01)    *H01F 7/18* (2006.01)

(52) Cooperative Patent Classification (CPC):
**F15B 19/005; F15B 13/044; F15B 20/008;
F16K 37/0041; F16K 37/0083; G01R 31/2829;
H01F 7/1844;** F15B 2013/0409; F15B 2211/327;
F15B 2211/634; F15B 2211/8636; F15B 2211/87

(86) International application number:
**PCT/IB2019/057045**

(87) International publication number:
**WO 2020/044175 (05.03.2020 Gazette 2020/10)**

(54) **A DIAGNOSTIC METHOD AND DEVICE FOR SOLENOID VALVES**

DIAGNOSEVERFAHREN UND -VORRICHTUNG FÜR MAGNETVENTILE

PROCÉDÉ ET DISPOSITIF DE DIAGNOSTIC POUR ÉLECTROVANNES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.08.2018 IT 201800008208**

(43) Date of publication of application:
**07.07.2021 Bulletin 2021/27**

(73) Proprietor: **Camozzi Automation S.p.A.
25126 Brescia (IT)**

(72) Inventors:
• **FERRARINI, Dario
25126 Brescia (IT)**
• **CAMISANI, Andrea
25126 Brescia (IT)**

(74) Representative: **Chimini, Francesco
Jacobacci & Partners S.p.A.
Piazza della Vittoria 11
25122 Brescia (IT)**

(56) References cited:
**EP-A1- 2 551 684    WO-A1-2019/043572
DE-A1- 3 807 278    DE-U1- 29 923 204
US-B2- 7 936 549**

**Description**

The present invention concerns a diagnostic device for solenoid valves.

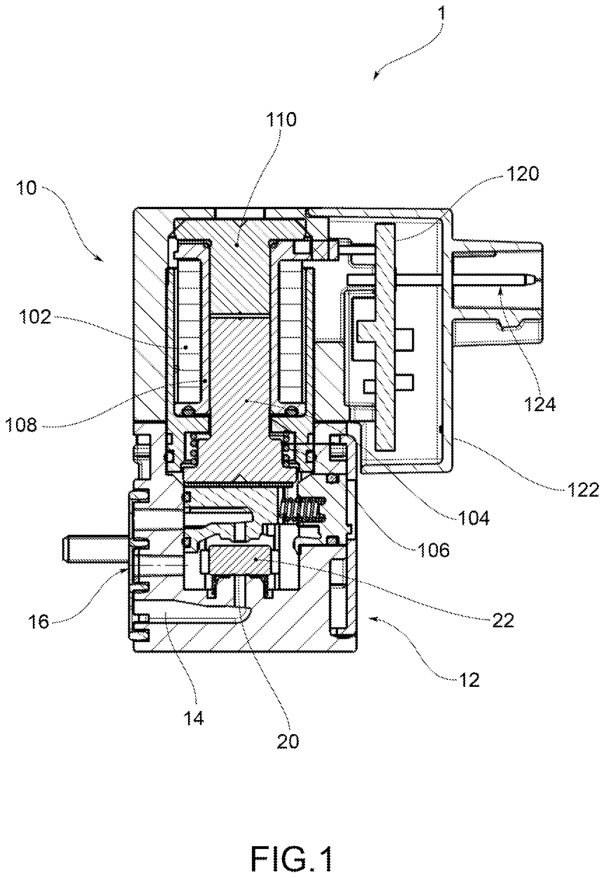

As shown in the example in figure 1, a solenoid valve 1 or electromagnetic valve, is typically composed of an electromagnet 10 and a valve body 12, wherein one or more orifices are made.

The electromagnet 10 comprises a solenoid 102 wherein is situated and slidable a movable core 104 made of ferromagnetic material. The flow through an orifice of a fluid intercepted by the solenoid valve, e.g. compressed air, is blocked or allowed by the movement of the movable core 104 when the solenoid is electrically powered or is deactivated.

When the solenoid 102 is powered, the movable core 104 directly opens the orifice of a normally closed (NC) valve or closes the orifice of a normally open (NO) valve. When the solenoid is deactivated, a spring 106 returns the core to its original position.

The valve operates in a pressure range from 0 bar to the maximum pressure rating. The force required to open the valve is proportional to the section of the orifice and the pressure of the fluid.

In the field of pneumatics for industrial automation, the performance of pneumatic components is increasingly high and must be guaranteed over time. In some applications, pneumatic components need to be replaced as soon as performance declines.

US 7 936 549 B2 discloses a known diagnostic method for diagnosing a malfunction in a solenoid valve.

In particular, there is an increasing need to monitor the behavior of solenoid valves to detect possible malfunctions or a significant reduction in the performance thereof.

The object of the present invention is to meet such a need by providing a diagnostic device capable of monitoring the performance of a solenoid valve to detect a deviation from the expected values thereof, for example, due to a malfunction or degradation due to wear.

Another object of the invention is to propose a diagnostic device suitable to be implemented directly on a solenoid valve, also - when possible - as an accessory to be applied to an existing solenoid valve.

These and other objects and advantages of the invention are achieved with a diagnostic method according to claim 1, with a diagnostic device according to claim 5, and with a solenoid valve according to claim 9.

The dependent claims describe preferred embodiments of the invention.

Further features and advantages of the device and of the diagnostic method according to the invention will nevertheless become evident from the description of the preferred embodiments thereof provided hereinafter by way of indicative and non-limiting example, with reference to the accompanying figures, wherein:

- Figure 1 is a sectional view of a solenoid valve according to the state of the art;
- Figure 2 is a sectional view of a solenoid valve equipped with a diagnostic device according to the invention;
- Figure 3 is a graph representing a typical waveform of the solenoid current;
- Figures 4 and 4a represent two graphs of the waveform of the solenoid current in the presence of friction between the movable core and the solenoid;
- Figure 5 is a flow diagram of a diagnostic algorithm, in one embodiment;
- Figure 6 is a circuit diagram of a detection circuit of the peak current of the waveform of the solenoid current;

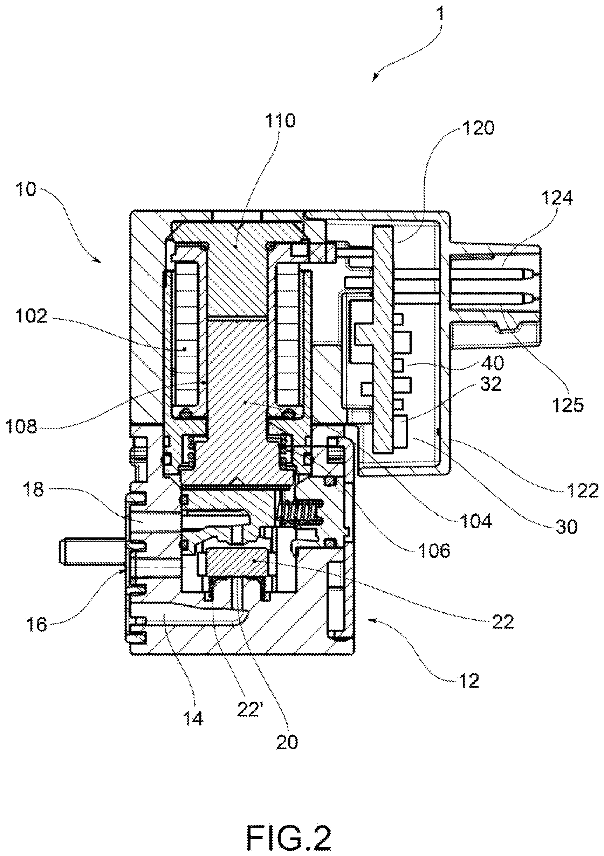

Figure 2 shows a solenoid valve 1 equipped with a diagnostic device according to the invention.

The solenoid valve 1 comprises an electromagnet 10 and a valve body 12 wherein an inlet orifice 14, an outlet orifice 16 and a discharge passage 18 are made.

The inlet orifice 14 forms a valve seat 20 to which is associated a sealing valve element 22 that is movable between a closed position and an open position of the valve seat 20.

The electromagnet 10 comprises a solenoid 102 wound on a coil 108 and a magnetic circuit formed of a fixed plunger 110, having for example a portion that partially penetrates the axial sleeve of the coil 108, and a movable core 104, which also partially penetrates in the sleeve.

The valve element 22 may be constructed as an integral part of the movable core 104 or as a separate element. In some embodiments, the sealing valve element 22 has a cylindrical base with comb teeth facing the movable core.

If the valve element is made as a separate element - as in the example in figure 2 - a spring 22', placed under its cylindrical base, has the task of pushing the valve element towards the movable core 104 as the position of the latter changes.

The solenoid 102 has a pair of electrical terminals connected to a power supply and control circuit board 120 housed in a protective casing 122 integral with the electromagnet 10. In turn, the power supply and control circuit board 120 is provided with power supply terminals 124 suitable to be connected to a power supply connector.

In accordance with one aspect of the invention, the diagnostic device comprises an electrical diagnostic circuit 30 implemented on the power supply and control circuit board 120.

In a direct current valve of the type described above, powered with a constant power supply voltage, for example 24V, 12V, or 5V, as soon as the solenoid 102 is energized, the current in the solenoid increases, causing an expansion of the magnetic field, until it becomes sufficiently elevated to move the movable core 104. The movement of the movable core 104 increases the concentration of the magnetic field, as the magnetic mass of the core moves increasingly to the inside of the magnetic field.

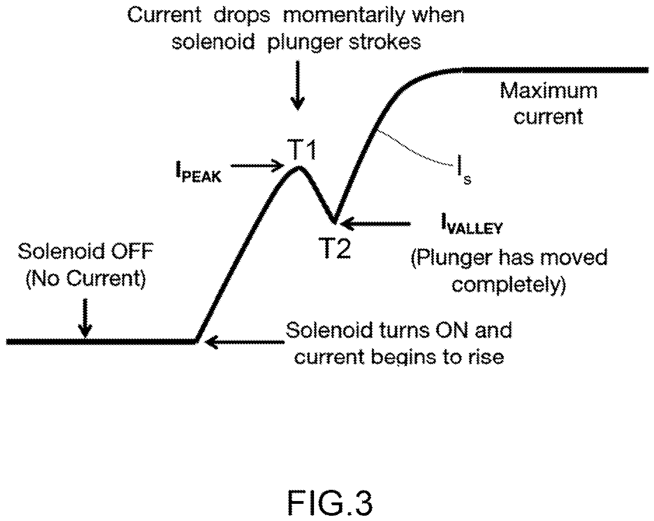

A magnetic field, which changes in the same direction as the current that generates it, induces a voltage of the opposite sign in the solenoid coils. Since the magnetic field expands rapidly as the movable core moves to the end-of-stroke position, such a field causes a brief reduction in the current flowing through the winding of the solenoid. After the movable core has reached the end of its stroke, the current begins to increase again until it reaches its maximum level. A typical waveform of the solenoid current IS is shown in Figure 3.

As long as no power supply voltage is applied to the solenoid, the solenoid current is zero.

When the solenoid is powered, there is a first increase of the solenoid current IS, until reaching, at the time T1, a peak value $I_{PEAK}$, which, as stated, corresponds to the engagement of the movable core, i.e., the beginning of its stroke towards the fixed plunger. The solenoid current then decreases until it reaches, at the moment T2, a minimum value $I_{VALLEY}$, which corresponds to the abutment of the movable core against the fixed plunger. At this point, the solenoid current begins to increase again until it reaches its maximum value.

The simplified equation of the solenoid of a solenoid valve could be represented as follows:

$$V = iR + \frac{d\Phi(i,x)}{dt}$$

where V is the voltage applied to the solenoid, R is the resistance of the solenoid and $\Phi$ expresses the variation in magnetic flux as a function of the current and the position (x) of the movable mechanical parts (movable core and fixed core, or plunger).

The first term of the equation is relative to the change in resistance and the second term expresses the induced voltage.

The solenoid inductance depends on the position of the movable parts, as the magnetic reluctance of the solenoid depends on the position of the electromagnetic parts and therefore on the reclosing of the magnetic field itself.

The flux $\Phi$ in the coil depends on the current passing through the coil and the distance of the ferrous parts, according to the formula:

$$V = iR + \frac{\delta\Phi(i,x)}{\delta i} * \frac{di}{dt} + \frac{\delta\Phi(i,x)}{\delta x} * \frac{dx}{dt}$$

Being $\Phi$ = Li, the preceding relationship becomes:

$$V = iR + L(i,x) * \frac{di}{dt} + i * \frac{dL(i,x)}{dx} * \frac{di}{dt}$$

The third addend represents the counter-electromotor force induced by the movement of the ferrous parts.

This relationship clearly shows that the magnetic flux and thus the attractive force of the solenoid valve depend on the values of the resistance R and the inductance L of the solenoid.

It is known, moreover, that the resistance R of a solenoid is given by the relationship

$$R = \rho * l/S$$

where $\rho$ is the average resistivity of the material, 1 is the length of the wire and S is the section.

$\rho$ and S may be assumed as constants, while the length l is subject to thermal expansion, which may be expressed thusly:

$$R = R(T0) * [1 + \sigma(T - T0)]$$

where T0 is the temperature at 20° and $\sigma$ is the material-dependent thermal coefficient.

Returning now to the waveform of the solenoid current, it may be observed that such waveform is substantially independent of the temperature.

On the other hand, it has been found that the waveform of the solenoid current, and in particular the time interval T1 between the solenoid excitation and the peak current $I_{PEAK}$ preceding the temporary drop, depends on the pressure of the fluid in the inlet orifice and/or on the wear of the solenoid valve, which is reflected, for example, in deformations of the sealing valve element, loss of spring force, friction.

According to the invention, the solenoid current values are obtained by sampling the waveform at predetermined time intervals using a current sampling circuit.

In one advantageous embodiment the diagnostic circuit 30 being implemented in the same power supply and control circuit board 120 that is already provided on the solenoid valve, this diagnostic circuit must be optimized in terms of bulk and therefore size and number of electronic components. For example, the diagnostic circuit 30 comprises a microcontroller 32, the computing power and memory of which are selected so that they may be mounted on the power supply and control circuit board 120 without affecting the dimensions of the latter.

Therefore, even an existing solenoid valve may be equipped with a diagnostic device by simply replacing the traditional power supply and control circuit board with a power supply, control and diagnostic circuit board having the same dimensions as the former.

For this purpose, the microcontroller 32 compares each value of the sampled current received by the sampling circuit with the previous value of the sampled current and stores the sampled value in the memory only if the outcome of the comparison reveals the attainment of the peak current or of the minimum current.

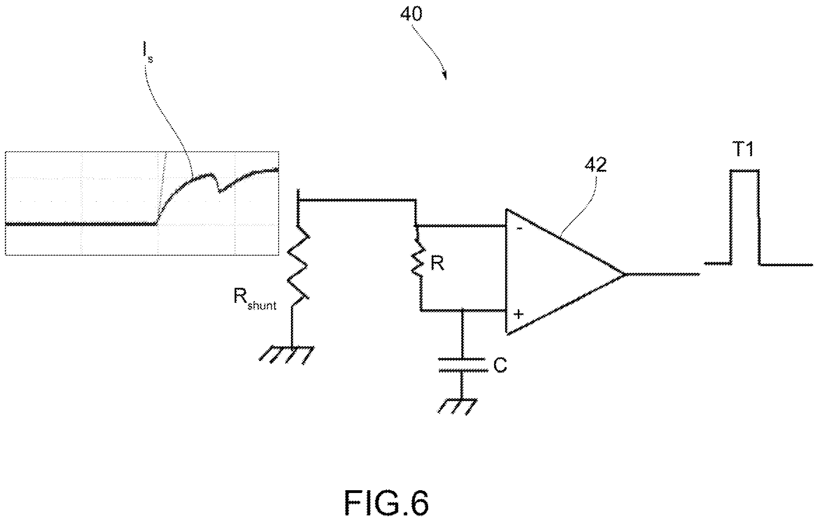

To detect the moment of time T1, according to the invention, the diagnostic device comprises an analog peak detection circuit 40, as shown in figure 6. In this circuit, the solenoid current detected by a shunt resistor RSHUNT (inverting input) and the solenoid current to which is applied a delay given by an RC network (non-inverting input) are fed to the input terminals of an operational amplifier 42 with comparator function. In this way, the circuit is able to detect the moment T1 wherein the solenoid current reaches the peak value $I_{PEAK}$.

From the analysis of the solenoid current waveforms over time, it was noted that some evident malfunctions or failures of solenoid valves were preceded by the appearance of an inflection or even relative minimum and maximum points in the descending segment of the current waveform, between the peak value ($I_{PEAK}$) and the absolute minimum value ($I_{VALLEY}$). Since this segment of the curve of the solenoid current waveform corresponds to the phase of movement of the movable core, such variations in the slope of this curve segment may be due to deterioration of the solenoid valve due in particular to friction between the movable core and the solenoid.

In accordance with one aspect of the invention, the diagnostic method is therefore based on an observation of the slope of this segment of the current waveform curve between the current peak (moment T1) and the minimum current value (moment T2).

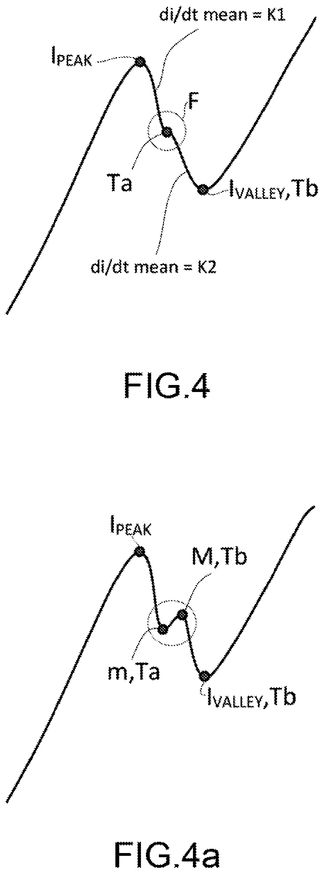

As said and with reference to Figures 4 and 4a, slope variation refers in particular to the appearance of an inflection F (Figure 4) or further relative minimum (m) and maximum (M) points (Figure 4a), as in the waveform portions circled in the drawings.

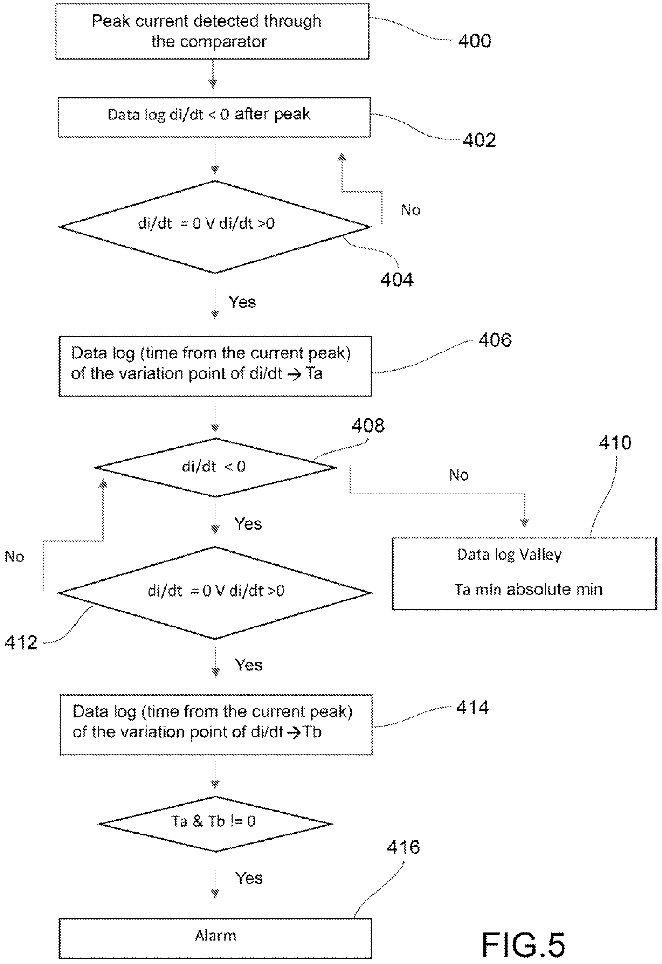

An example of a diagnostic protocol for this embodiment is shown in the flow diagram in figure 5.

With reference to the flow diagram in Figure 5, the current peak $I_{PEAK}$ (step 400) is detected by means of the peak current detection circuit by means of the comparator circuit.

After such detection, for example by sending a peak detect interrupt, the diagnostic circuit, by means of a microcontroller that receives the interrupt and by means of a voltage sampling circuit on the shunt, samples the current circulating in the solenoid, and in particular its rate of change K1' over time (di/dt) (step 402).

In one embodiment, the value of such gradient K1' is compared with a predetermined value K1.

If the gradient of the current in the solenoid is negative, it means that the movable core continues its movement with a dynamic proportional to the value K1' of the gradient itself.

The derivative of the current over time (di/dt) is calculated continuously, sampling the current in a time range contiguous to the one wherein the waveform peak occurred.

In the event of a null or positive value of the derivative of the current (di/dt) (step 404) the time value Ta corresponding to this value (step 406) is stored by the microcontroller.

The calculation of the derivative of the current over time (di/dt) continues in order to establish if the gradient remains negative (step 408).

In one embodiment, the average value of such derivative, in this observation phase, may be stored in the parameter K2' and compared with a second reference value K2.

If the gradient K2' always remains positive, it means that the point of the waveform at the moment Ta previously detected was an absolute minimum point, i.e., the point $I_{VALLEY}$, and therefore the moment Ta coincides with the moment T2 (step 410).

In the event of a second null or positive value of the current derivative (di/dt) (step 412), the time value Tb corresponding to such value (step 414) is stored, for example by the microcontroller.

Note that the values for the moments in time Ta, Tb and the gradients K1' and K2' are initialized to zero for each solenoid activation.

The simultaneous presence, after the detection of the current peak, of two non-null values Ta and Tb and/or of at least one of the lower values of the detected gradients K1', K2', in absolute value, with respect to the predetermined value K1, K2, indicates that during the movement of the movable core a discontinuity in the displacement dynamics has occurred, due to friction.

As regards the gradients K1' and K2', in particular, a negative but lower value, in absolute value, than the predetermined values K1, K2 indicates that the slope of the descending segment of the curve is lower than a predetermined slope due to the presence of friction in the stroke of the movable core.

The diagnostic circuit thus generates an alarm signal (step 416).

As mentioned above, in one embodiment the diagnostic device is implemented on the power supply and control circuit board 120 of the solenoid valve and is suitable to communicate with an external control unit, such as a PLC, using a communication protocol based on a single diagnostic cable 125, which becomes the third cable of the solenoid valve, in addition to the two power cables 124. Thus, the alarm signal relative to a deterioration of the solenoid valve may be sent to this external control unit.

It should be noted that the aforementioned diagnostic cable may be replaced by a wireless communication system, according to the needs and available technology.

If, on the other hand, the diagnostic device is not connected to an external control unit, a visual indication of the anomalous operating status may be given, for example, by flashing an LED at a certain frequency.

In one embodiment, the values K1', K2' of the derivatives of the waveform of the solenoid current are compared with corresponding values K1, K2 of the derivatives calculated in a test phase of the solenoid valve during or after its release from the factory, or at the beginning of its life cycle, so as to detect any significant variations caused by the wear of the solenoid valve, as explained above.

In a variant embodiment, the derivatives of the waveform detected are compared with the values of the derivatives calculated in the previous excitation of the solenoid valve (or with average values relative to a certain number of previous excitations).

## Claims

1. A diagnostic method for diagnosing a malfunction in a solenoid valve, wherein the solenoid valve comprises an electromagnet (10) and a valve body (12) wherein one or more orifices (14, 16, 18) are provided for the passage of a pressurized fluid and wherein the electromagnet (10) comprises a solenoid (102) which may be powered with a solenoid current and a magnetic circuit comprising a movable core (104) placed and slidable in the solenoid, the method comprising the steps of:

    a) detecting the first current peak ($I_{PEAK}$) of the solenoid current generated by the engagement of the movable core;

    b) verifying, by means of a current waveform sampling circuit sampling the waveform at predetermined time intervals after detection of the first current peak has occurred , if the waveform of the solenoid current has, after said first current peak and before reaching a minimum current value ($I_{VALLEY}$) corresponding to the end of the stroke of the movable core inside the solenoid, an inflection and/or other relative minimum (m) and maximum (M) points, wherein the first current peak is detected by means of an analog peak detection circuit (40) which compares the value of the instantaneous solenoid current with the value of the solenoid current to which a predetermined delay is applied.

2. A method according to the preceding claim, wherein, if the presence of said inflection and/or of said other relative maximum (M) and minimum (m) points is detected, an alarm signal is generated.

3. A method according to claim 1 or 2, wherein the presence of said inflection and/or said other relative maximum (M) and minimum (m) points is detected by calculating the derivative of the current over time (di/dt) and verifying if said derivative assumes a null or positive value in two moments of time (Ta, Tb) in a time interval following the moment wherein said peak of the waveform is verified and before the solenoid current reaches the steady state value.

4. A method according to any one of the preceding claims, further comprising the steps of:

    - calculating the average values of the derivative of the current over time in an immediately preceding time interval and in a time interval immediately following the inflection point or relative minimum point;
    - comparing said average values with the corresponding predetermined values;

- if at least one of said mean values is less in absolute value than the corresponding predetermined value, generating an alarm signal.

5. A diagnostic device for diagnosing a malfunction in a solenoid valve, where the solenoid valve comprises an electromagnet (10) and a valve body (12) wherein one or more orifices (14, 16, 18) are provided for the passage of a pressurized fluid and where the electromagnet (10) comprises a solenoid (102) which may be supplied with a solenoid current and a magnetic circuit comprising a movable core (104) placed and slidable in the solenoid, the diagnostic device comprising an electronic diagnostic circuit with a current sampling circuit suitable to sample the waveform at predetermined time intervals, an analog peak detection circuit (40) comprising an operational amplifier (42) with comparator function, to the inverting input terminal of which is carried the solenoid current detected through a shunt resistor (RSHUNT) and to the non-inverting input terminal of which is reported the solenoid current to which is applied a delay given by an RC network, and a microcontroller configured to implement the diagnostic method according to any one of the preceding claims.

6. A device according to the preceding claim, wherein the diagnostic circuit is implemented on a power supply and control circuit board suitable to be mounted on the solenoid valve.

7. A device according to claim 5 or 6, comprising communication means suitable to implement a communication between the microcontroller of the electronic diagnostic circuit and an external control unit.

8. A device according to the preceding claim, wherein said communication means are suitable to transmit a status signal to the external control unit, which may assume at least two logical levels representative of the operational state of the solenoid valve.

9. A solenoid valve comprising an electromagnet (10) and a valve body (12), wherein one or more orifices (14, 16, 18) are provided for the passage of a pressurized fluid and wherein the electromagnet (10) comprises a solenoid (102) which may be powered with a solenoid current and a magnetic circuit comprising a movable core (104) placed and slidable in the solenoid, the solenoid valve further comprising a diagnostic device according to any one of claims 5-8.

10. A solenoid valve according to the preceding claim, comprising a power supply and control circuit board (120), the diagnostic device being implemented on said power supply and control circuit board (120).

11. A solenoid valve according to the preceding claim, wherein the power supply and control circuit board is provided with an electrical connector having a pair of power supply terminals and an electrical diagnostic terminal connectable to an external control unit.

## Patentansprüche

1. Diagnoseverfahren zum Diagnostizieren einer Fehlfunktion bei einem Solenoidventil, wobei das Solenoidventil einen Elektromagneten (10) und einen Ventilkörper (12) umfasst, wobei eine oder mehrere Öffnungen (14, 16, 18) für den Durchgang eines unter Druck stehenden Fluids bereitgestellt sind und wobei der Elektromagnet (10) ein Solenoid (102), welches mit einem Solenoid-Strom betrieben werden kann, und einen magnetischen Kreis umfasst, welcher einen bewegbaren Kern (104) umfasst, welcher in dem Solenoid platziert und darin verschiebbar ist, wobei das Verfahren die folgenden Schritte umfasst:

a) Detektieren der ersten Stromspitze ($I_{PEAK}$) des Solenoidstroms, welcher durch die Interaktion des bewegbaren Kerns erzeugt wird;
b) Verifizieren, mittels einer Stromwellenform-Abtastschaltung, welche die Wellenform bei vorbestimmten Zeitintervallen abtastet, nachdem eine Detektion der ersten Stromspitze aufgetreten ist, ob die Wellenform des Solenoidstroms, nach der ersten Stromspitze und vor einem Erreichen eines minimalen Stromwerts ($I_{VALLEY}$), welcher dem Ende des Hubes des bewegbaren Kerns innerhalb des Soleniods entspricht, einen Wendepunkt und/oder andere relative Minimum (m)- und Maximum (M)-Punkte aufweist, wobei die erste Stromspitze mittels einer analogen Spitzendetektionsschaltung (40) detektiert wird, welche den Wert des momentanen Solenoidstroms mit dem Wert des Solenoidstroms vergleicht, auf welchen eine vorbestimmte Verzögerung angewendet ist.

2. Verfahren nach dem vorhergehenden Anspruch, wobei, wenn das Vorhandensein des Wendepunkts und/oder der anderen relativen Maximum (M)- und Minimum (m)-Punkte detektiert wird, ein Alarmsignal erzeugt wird.

3. Verfahren nach Anspruch 1 oder 2, wobei das Vorhandensein des Wendepunkts und/oder der anderen relativen Maximum (M)- und Minimum (m)-Punkte detektiert wird, indem die Ableitung des Stroms über der Zeit (di/dt) berechnet wird und verifiziert wird, ob die Ableitung einen Null-Wert oder einen positiven Wert zu zwei Zeitpunkten (Ta, Tb) einnimmt, in einem Zeitintervall, welches dem Moment folgt, in welchem die Spitze der Wellenform verifiziert wird, und bevor der Solenoidstrom den Wert eines stationären Zustands erreicht.

4. Verfahren nach einem der vorhergehenden Ansprüche, ferner umfassend die folgenden Schritte:

   - Berechnen der Durchschnittswerte der Ableitung des Stroms über der Zeit in einem unmittelbar vorhergehenden Zeitintervall und in einem Zeitintervall, welches dem Wendepunkt oder dem relativen Minimum-Punkt unmittelbar folgt;
   - Vergleichen der Durchschnittswerte mit den entsprechenden vorbestimmten Werten;
   - wenn wenigstens einer der Mittelwerte bezügliches eines Absolutwerts geringer als der entsprechende vorbestimmte Wert ist, Erzeugen eines Alarmsignals.

5. Diagnosevorrichtung zum Diagnostizieren einer Fehlfunktion bei einem Solenoidventil, wobei das Solenoidventil einen Elektromagneten (10) und einen Ventilkörper (12) umfasst, wobei eine oder mehrere Öffnungen (14, 16, 18) für den Durchgang eines unter Druck stehenden Fluids bereitgestellt sind und wobei der Elektromagnet (10) ein Solenoid (102), welches mit einem Solenoid-Strom versorgt werden kann, und einen magnetischen Kreis umfasst, welcher einen bewegbaren Kern (104) umfasst, welcher in dem Solenoid platziert und darin verschiebbar ist, wobei die Diagnosevorrichtung eine elektronische Diagnoseschaltung mit einer Stromabtastschaltung, welche dazu geeignet ist, die Wellenform bei vorbestimmten Zeitintervallen abzutasten, eine analoge Spitzendetektionsschaltung (40), umfassend einen Operationsverstärker (42) mit einer Komparator-Funktion, zu dessen invertierendem Eingangsanschluss der Solenoidstrom durch einen Shunt-Widerstand (RSHUNT) geführt wird und zu dessen nicht-invertierendem Eingangsanschluss der Solenoidstrom gemeldet wird, auf welchen eine Verzögerung angewendet ist, welche durch ein RC-Netzwerk gegeben ist, und einen Mikrocontroller umfasst, welcher dazu eingerichtet ist, das Diagnoseverfahren nach einem der vorhergehenden Ansprüche zu implementieren.

6. Vorrichtung nach dem vorhergehenden Anspruch, wobei die Diagnoseschaltung auf einer Energieversorgung-und-Steuerschaltung-Platte implementiert ist, welche dazu geeignet ist, an dem Solenoidventil montiert zu sein.

7. Vorrichtung nach Anspruch 5 oder 6, umfassend Kommunikationsmittel, welche dazu geeignet sind, eine Kommunikation zwischen dem Mikrocontroller der elektronischen Diagnoseschaltung und einer externen Steuereinheit zu implementieren.

8. Vorrichtung nach dem vorhergehenden Anspruch, wobei die Kommunikationsmittel dazu geeignet sind, ein Statussignal an die externe Steuereinheit zu übertragen, welches wenigstens zwei logische Pegel einnehmen kann, welche für den Betriebszustand des Solenoidventils repräsentativ sind.

9. Solenoidventil, welches einen Elektromagneten (10) und einen Ventilkörper (12) umfasst, wobei eine oder mehrere Öffnungen (14, 16, 18) für den Durchgang eines unter Druck stehenden Fluids bereitgestellt sind und wobei der Elektromagnet (10) ein Solenoid (102), welches mit einem Solenoid-Strom betrieben werden kann, und einen magnetischen Kreis umfasst, welcher einen bewegbaren Kern (104) umfasst, welcher in dem Solenoid platziert und darin verschiebbar ist, wobei das Solenoidventil ferner eine Diagnosevorrichtung nach einem der Ansprüche 5-8 umfasst.

10. Solenoidventil nach dem vorhergehenden Anspruch, umfassend eine Energieversorgung-und-Steuerschaltung-Platte (120), wobei die Diagnosevorrichtung auf der Energieversorgung-und-Steuerschaltung-Platte (120) implementiert ist.

11. Solenoidventil nach dem vorhergehenden Anspruch, wobei die Energieversorgung-und-Steuerschaltung-Platte mit einem elektrischen Verbinder bereitgestellt ist, welcher ein Paar von Energieversorgungsanschlüssen und einen elektrischen Diagnoseanschluss aufweist, welcher mit einer externen Steuereinheit verbindbar ist.

**Revendications**

1. Procédé de diagnostic pour diagnostiquer un dysfonctionnement dans une soupape à solénoïde, dans lequel la soupape à solénoïde comprend un électroaimant (10) et un corps de soupape (12) dans lequel un ou plusieurs orifices (14, 16, 18) sont prévus pour le passage d'un fluide sous pression et dans lequel l'électroaimant (10) comprend un solénoïde (102) qui peut être alimenté par un courant de solénoïde et un circuit magnétique comprenant un noyau mobile (104) placé et coulissant dans le solénoïde, le procédé comprenant les étapes consistant à :

   a) détecter le premier pic de courant ($I_{PEAK}$) du courant de solénoïde généré par la mise en prise du noyau mobile ;
   b) vérifier, au moyen d'un circuit d'échantillonnage de forme d'onde de courant échantillonnant la forme d'onde à des intervalles de temps prédéterminés après la détection du premier pic de courant, si la forme d'onde du courant de solénoïde a, après ledit premier pic de courant et avant d'atteindre une valeur de courant minimale ($I_{VALLEY}$) correspondant à la fin de la course du noyau mobile à l'intérieur du solénoïde, une inflexion et/ou d'autres points relatifs minimum (m) et maximum (M), dans lequel le premier pic de courant est détecté au moyen d'un circuit de détection de pic analogique (40) qui compare la valeur du courant de solénoïde instantané à la valeur du courant de solénoïde auquel est appliqué un retard prédéterminé.

2. Procédé selon la revendication précédente, dans lequel, si la présence de ladite inflexion et/ou desdits autres points relatifs maximum (M) et minimum (m) est détectée, un signal d'alarme est généré.

3. Procédé selon la revendication 1 ou 2, dans lequel la présence de ladite inflexion et/ou desdits autres points relatifs maximum (M) et minimum (m) est détectée par le calcul de la dérivée du courant dans le temps (di/dt) et la vérification si ladite dérivée prend une valeur nulle ou positive en deux instants de temps (Ta, Tb) dans un intervalle de temps suivant l'instant dans lequel ledit pic de la forme d'onde est vérifié et avant que le courant de solénoïde n'atteigne la valeur d'état stable.

4. Procédé selon l'une quelconque des revendications précédentes, comprenant en outre les étapes consistant à :

   - calculer les valeurs moyennes de la dérivée du courant dans le temps dans un intervalle de temps immédiatement précédent et dans un intervalle de temps immédiatement après le point d'inflexion ou le point minimum relatif ;
   - comparer lesdites valeurs moyennes aux valeurs prédéterminées correspondantes ;
   - si au moins une parmi lesdites valeurs moyennes est inférieure en valeur absolue à la valeur prédéterminée correspondante, générer un signal d'alarme.

5. Dispositif de diagnostic pour diagnostiquer un dysfonctionnement dans une soupape à solénoïde, où la soupape à solénoïde comprend un électroaimant (10) et un corps de soupape (12) dans lequel un ou plusieurs orifices (14, 16, 18) sont prévus pour le passage d'un fluide sous pression et où l'électroaimant (10) comprend un solénoïde (102) qui peut être alimenté par un courant de solénoïde et un circuit magnétique comprenant un noyau mobile (104) placé et coulissant dans le solénoïde, le dispositif de diagnostic comprenant un circuit électronique de diagnostic avec un circuit d'échantillonnage de courant approprié pour échantillonner la forme d'onde à des intervalles de temps prédéterminés, un circuit de détection de pic analogique (40) comprenant un amplificateur opérationnel (42) à fonction de comparateur, à la borne d'entrée inverseuse dont est acheminé le courant de solénoïde détecté à travers une résistance shunt (RSHUNT) et à la borne d'entrée non inverseuse dont est rapporté le courant de solénoïde auquel est appliqué un retard donné par un réseau RC, et un microdispositif de commande configuré pour mettre en oeuvre le procédé de diagnostic selon l'une quelconque des revendications précédentes.

6. Dispositif selon la revendication précédente, dans lequel le circuit de diagnostic est implémenté sur une carte de circuit d'alimentation en puissance et de commande appropriée pour être montée sur la soupape à solénoïde.

7. Dispositif selon la revendication 5 ou 6, comprenant des moyens de communication appropriés pour implémenter une communication entre le microdispositif de commande du circuit électronique de diagnostic et une unité de commande extérieure.

8. Dispositif selon la revendication précédente, dans lequel lesdits moyens de communication sont appropriés pour émettre un signal d'état à l'unité de commande extérieure, qui peut prendre au moins deux niveaux logiques représentatifs de l'état de fonctionnement de la soupape à solénoïde.

9. Soupape à solénoïde comprenant un électroaimant (10) et un corps de soupape (12), dans laquelle un ou plusieurs orifices (14, 16, 18) sont prévus pour le passage d'un fluide sous pression et dans laquelle l'électroaimant (10) comprend un solénoïde (102) qui peut être alimentée par un courant de solénoïde et un circuit magnétique comprenant un noyau mobile (104) placé et coulissant dans le solénoïde, la soupape à solénoïde comprenant en outre un dispositif de diagnostic selon l'une quelconque des revendications 5 à 8

10. Soupape à solénoïde selon la revendication précédente, comprenant une carte de circuit d'alimentation en puissance et de commande (120), le dispositif de diagnostic étant implémenté sur ladite carte de circuit d'alimentation en puissance et de commande (120).

11. Soupape à solénoïde selon la revendication précédente, dans laquelle la carte de circuit d'alimentation en puissance et de commande est dotée d'un raccord électrique ayant une paire de bornes d'alimentation en puissance et une borne de diagnostic électrique pouvant être raccordée à une unité de commande extérieure.

FIG.1

FIG.2

FIG.3

di/dt mean = K1

$I_{PEAK}$

F

Ta

$I_{VALLEY}$,Tb

di/dt mean = K2

# FIG.4

$I_{PEAK}$

M,Tb

m,Ta

$I_{VALLEY}$,Tb

# FIG.4a

Peak current detected through
the comparator —— 400

Data log di/dt < 0 after peak —— 402

di/dt = 0 V di/dt >0 — No — 404

Yes

Data log (time from the current peak)
of the variation point of di/dt → Ta —— 406

408 — di/dt < 0 — No — 410

Yes

Data log Valley
Ta min absolute min

di/dt = 0 V di/dt >0 — No

412

Yes

Data log (time from the current peak)
of the variation point of di/dt → Tb —— 414

Ta & Tb != 0

Yes — 416

Alarm

FIG.5

FIG.6

**EP 3 844 402 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7936549 B2